# EUROPEAN PATENT APPLICATION

(11) **EP 1 737 086 A1**
(43) Date of publication of application: **27.12.2006**
(21) Application number: 05728835.9
(22) Date of filing: 31.03.2005
(51) Int. Cl.: H01R 43/02

(54) **LIGHT BEAM BONDING**

(30) Priority: 31.03.2004 JP 2004107905
(71) Applicant: FCI Connectors Singapore Pte Ltd., Singapore 238874 (SG)
(72) Inventor: OKANO, Kazuya;, Yokohama-shi, Kanagawa; 2400016 (JP)
(74) Representative: Cabinet Plasseraud
(86) International application number: PCT/JP2005/006285
(87) International publication number: WO 2005/096458

(57) **Abstract**

A method for performing soldering using a light beam, and a mask for blocking the light beam are provided. A connecting method is provided, being a method for connecting conducting lines and contacts using a light beam, including a step for installing conducting lines in regions wherein contacts are formed, a step for supplying solder to regions wherein contacts are formed, a step for installing a mask that shields at least a portion of the contacts from a light beam, and a step for connecting conducting lines and contacts by melting solder by illuminating with a light beam.

## Description

### [Technical Field]

The present invention concerns light beam bonding, wherein, when soldering of an electrical device is performed, the portion being soldered is illuminated with light, and connecting is done by melting the solder with light energy.

### [Background Art]

Normally, electrical connections such as the connection between contacts formed on a connector housing and conducting lines is performed using solder and a soldering device, while applying physical contact. However, in recent years, in order to realize high performance with small communication devices such as cellular telephones, a large number of electrical parts are needed in a restricted space, so the miniaturization of connectors is also demanded.

Normally, connectors are equipped with a plurality of contacts, and in cases where a plurality of thin conducting lines are being connected, it is difficult to manufacture connectors using a method that is normally used, such as putting a portion that is a heat source, such as a soldering device, into physical contact with the object.
[Patent Document 1] JP-A 2001-244030

### [Disclosure of the Invention]

### [Problem to be Solved by the Invention]

This is because the size of contacts and conducting lines is small, so that various restrictions arise when manufacturing such miniature connectors, because, for example, a soldering device must be pressed against the contacts.

Also, even in cases of soldering using so-called light beams, if the beam illuminates a portion other than the contacts, there are cases where, for example, the connector housing melts due to the strong energy of said beam.

### [Means for Solving the Problem]

In light of the above-described problems, the present invention provides a connecting method being a method for connecting conducting lines and contacts using a light beam, including a step wherein conducting lines are installed into a region where contacts are formed, a step wherein a mask that partially shields the contacts from the light beam is installed, and a step wherein solder is melted by illuminating with a light beam, thereby connecting the conducting lines with the contacts. Whereby, the connecting of the contacts and the conducting lines can be done while the portion protected by the mask is shielded from the beam and is not adversely affected.

A method is provided where, when using the mask in this way, in the step where the mask is installed, said mask shields at least a portion of the connector that is near the light beam source. Whereby, soldering can be done while the housing and the like are not adversely affected such as becoming deformed.

Additionally, the illumination of the beam is such that the beam illuminates the region to be illuminated continuously, so as to scan it. Whereby the control of the beam becomes easy.

Further, a method is provided where, for such soldering using a light beam, a step is included wherein the contacts are formed by MID. In this way, by combining MID and a light beam, the soldering of a connector that is miniature and whereof the contacts are, for example, installed at high density and three-dimensionally can be performed easily.

As a connector that can perform such a method, a connector is provided whereon contacts are formed, and a wall portion defining the region receiving the conductors of the conducting lines is formed on the upper surface of the connector, sandwiching the contacts, said wall portion being formed higher than the height of the conductors. Whereby, shorting with an adjacent contact or conducting line due to the splashing of solder during soldering can be prevented.

The structure of such a connector is such that the height of the aforementioned wall portion is approximately twice the height of the aforementioned conductors. That is, due to the wall portion being approximately twice the height of the conductors, even when solder splashes, it will be certain that the solder does not come into contact with an adjacent contact or conductor.

For such a connector, the contacts are optimally formed by MID. Additionally, the mask used is a mask for light beams that shields the regions other than the contacts from the light beam when the contacts and the conducting lines are connected using a light beam. Whereby, the connecting of the contacts and the conducting lines can easily be accommodated, and further, the deformation of the connectors can be prevented by the mask.

Additionally, it is possible to use this mask as a jig for performing positioning and the like by holding down the coaxial cable during the manufacture of the connector, so the manufacturing process can be simplified. Additionally, the mask material is optimally iron.

### [Brief Description of the Drawings]

[Figure 1] Figure 1 is an oblique perspective view of when conducting lines are placed on a connector and solder is supplied.
[Figure 2] Figure 2 is a front view of when a housing is installed on a connector.
[Figure 3] Figure 3 is an enlarged view of a portion shown in figure 2.

### [Explanation of Reference Numbers]

- 1: Connector
- 2: Contact
- 3: Coaxial Cable
- 4: Conducting Line
- 5: Solder
- 6: Wall Portion
- 7: Mask
- 8: Contact Region
- 9: Window
- 10: Portion of Connector Near Light Source

### [Best Mode for Embodying the Invention]

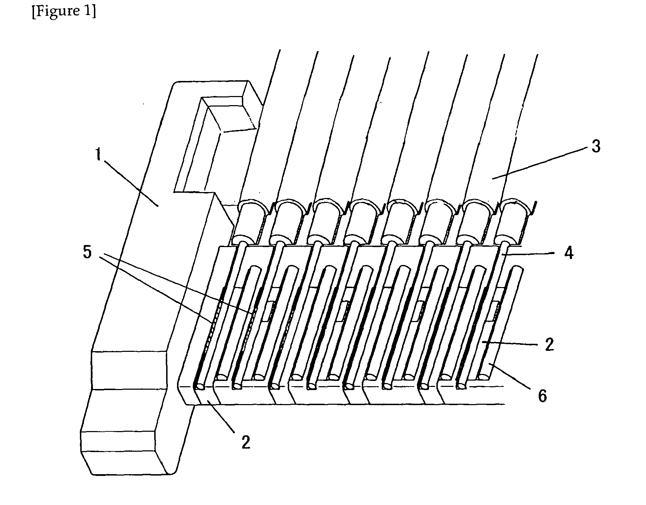

An embodiment of the present invention shall be explained below, using diagrams. Figure 1 is a diagram showing the situation when solder 5 and conducting lines 4 are placed on a connector.

Here, the solder is supplied in the state of a paste or a ball. Figure 1 shows solder in the form of a paste. The solder 5 is placed on the contacts 2, and when conducting lines 4 are placed on the contacts as shown in the diagram, solder 5 is placed between the contacts 2 and the conducting lines 4. These contacts are formed on the housing by so-called MID, and are formed in such a manner that they reach the lower surface by passing through a pass-through hole formed on the housing, or by passing along the side surface from the housing upper surface. It is easy to form such three-dimensionally formed contacts with MID, and by combining this with the method of the present invention, more effective effects can be achieved.

After the conducting lines 4 and the solder 5 have been placed on the connector 1 in this way, the task of soldering begins. Soldering is done by scanning a light beam in the horizontal direction so that all of the solder has been illuminated. Here, for the light beam, for example, a Soft Beam (registered trademark) or the like may be used.

Here, since the light beam has enough energy to melt the solder, deformation can occur during the scanning of said light beam if the light beam strikes regions other than those regions in which contacts are formed. In particular, depending upon the shape of the connector, portions near the light source may deform. Therefore, a mask is installed so that the light beam does not illuminate portions which do not need to be illuminated.

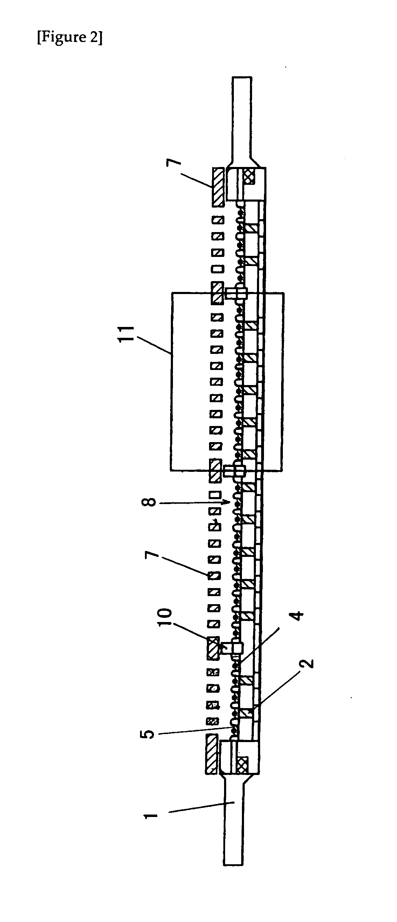

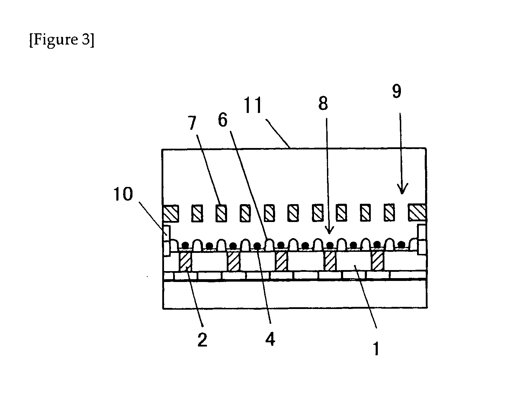

Figure 2 is a front view of the entire connector viewed from the axial direction of the conducting lines. Conducting lines 4 are placed on the connector 1, and solder 5 is supplied. Here, figures 1 and 2 show solder being supplied to a portion of the contacts 2 or the conducting lines 4, but it is obvious that it is supplied to all of the contacts 2 and the conducting lines 4. At this stage, a mask 7 is installed on the connector 1. Figure 3 shows an enlarged view of the portion indicated by reference number 11 in the state where a mask 7 is installed on a connector 1.

From figure 3, it can be seen that the regions shielded by the mask 7 are the wall portions 6 that partition the contact regions 8, and the upper portions 10 of the connector that are close to the light source. However, the shielded regions are not restricted by the present embodiments, and portions that would not be damaged such as by deformation due to the light beam do not have to be shielded. Additionally, windows 9 are opened on the mask above the contact regions 8 where the soldering is to be performed, and all other portions shield the light beam. The light beam passes through these windows 9 to illuminate the contact regions 8. Thereby, the light beam is continuously output, and the light beam can be scanned so as to illuminate all of the solder 5. Here, the mask 7 also functions as a jig to press on and anchor the coaxial cable.

In this way, soldering can be done using the light beam, and even for an extremely small structure such as a connector used in mobile telephones, and also even for cases where physical handling is difficult, soldering can be performed quickly and accurately. Further, it is desirable for the contacts 2 that are formed on the connector 1 to be formed by MID, in a separate process. Thereby, even for small and three-dimensionally structured contacts, for which the soldering task is difficult, it is possible to connect the conducting lines and the contacts easily, since there is no need for contact with the soldering means of a soldering device.

In the present embodiments, iron is assumed to be the material of the mask 7. This is because, for example, when a Soft Beam (registered trademark) is used as a light beam, a xenon light source is used as the light source of said Soft Beam, so that iron is used as a material that is optimal for this light source. However, there is no restriction to this, and as long as the material can block a light beam, metals, plastics, resins, and other material are also included in the range of the present invention.

The present invention further provides, as a structure of the connector 1, the structure of the wall portions that partition adjacent contact regions 8. As shown in figure 3, the height of the wall portions 6 from the housing 1 is greater than the diameter of the conducting lines 4. According to the present invention, the height of the wall portions 6 are at least approximately twice the diameter of the conducting lines 4. By making it this height, when solder is melted due to the light beam, shorting between adjacent contacts due to the splashing of solder can reliably be prevented.

## Claims

1. A connecting method, being a method for connecting conducting lines and contacts using a light beam;
including a step for installing conducting lines in regions wherein contacts are formed;
a step for supplying solder to regions wherein contacts are formed;
a step for installing a mask that at least partially shields a connector from a light beam,
and a step for connecting conducting lines and contacts by melting solder by illuminating with a light beam.

2. A method according to claim 1, wherein, in the step for installing the mask, said mask shields at least the portions of the connector that are close to the light beam.

3. A method according to claim 1, wherein the illumination of the light beam is performed so as to scan the region wherein bonding is to be done.

4. A method for connecting contacts and conducting lines, by a method according to claim 1, after forming contacts on a connector housing by MID.

5. A connector, being a connector for light beam bonding, contacts being formed on the housing thereof, wall portions defining the regions that accept the conductors of the conducting lines being formed on the upper surface of the connector in a direction parallel to the contacts or the conducting lines, said wall portions being formed higher than the height of the conductors.

6. A connector according to claim 5, whereof the height of the aforementioned wall portions is approximately twice the height of the aforementioned conducting lines.

7. A connector according to claim 5 or 6, whereof the contacts are formed by MID.

8. A mask for a light beam, being a mask for light beam bonding, said mask shielding a portion of the regions that are not contacts from a light beam, when connecting the contacts and the conducting lines with a light beam.

9. A mask according to claim 8, where the aforementioned mask is a jig that presses a coaxial cable against a connector during manufacture of the connector.

10. A mask according to claim 8, wherein the material of the aforementioned mask is iron.

## Amended claims

### Amended claims under Art. 19.1 PCT

**1.** A connecting method, being a method for connecting conducting lines and contacts using a light beam;
including a step for installing conducting lines in regions wherein contacts are formed;
a step for supplying solder to regions wherein contacts are formed;
a step for installing a mask that shields at least the regions between the contacts from a light beam,
and a step for connecting conducting lines and contacts by melting solder by illuminating with a light beam.

**2.** A method according to claim 1, wherein, in the step for installing the mask, said mask shields at least the portions of the connector that are close to the light beam.

**3.** A method according to claim 1, wherein the illumination of the light beam is performed so as to scan the region wherein bonding is to be done.

**4.** A method for connecting contacts and conducting lines, by a method according to claim 1, after forming contacts on a connector housing by MID.

**5.** A connector, being a connector for light beam bonding, contacts being formed on the housing thereof, wall portions defining the regions that accept the conductors of the conducting lines being formed on the upper surface of the connector in a direction parallel to the contacts or the conducting lines, said wall portions being formed higher than the height of the conductors.

**6.** A connector according to claim 5, whereof the height of the aforementioned wall portions is approximately twice the height of the aforementioned conducting lines.

**7.** A connector according to claim 5 or 6, whereof the contacts are formed by MID.

**8.** A mask for a light beam, being a mask for light beam bonding, said mask shielding a portion of the regions that are not contacts from a light beam, when connecting the contacts and the conducting lines with a light beam.

**9.** A mask according to claim 8, where the aforementioned mask is a jig that presses a coaxial cable against a connector during manufacture of the connector.

**10.** A mask according to claim 8, wherein the material of the aforementioned mask is iron.
